# EUROPEAN PATENT SPECIFICATION

(11) **EP 2 383 623 B1**
(45) Date of publication and mention of the grant of the patent: **05.12.2012**
(21) Application number: 10161648.0
(22) Date of filing: 30.04.2010
(51) Int. Cl.: G05B 19/042, B65B 57/00, G08C 23/04, H05K 7/14, H04B 10/00

(54) **Modular safety switching device system with optical link**
Modulares Sicherheitsschaltsystem mit optischer Verbindung
Système modulaire de dispositif de commutation sécurisée avec liaison optique

(43) Date of publication of application: 02.11.2011
(73) Proprietor: Rockwell Automation Germany GmbH & Co. KG, 42329 Wuppertal (DE)
(72) Inventor: Lorenz, Dirk, 58300 Wetter (DE); Machuletz, Norbert, 58300 Wetter (DE); Helpenstein, Thomas, 41515 Grevenbroich (DE); Papenbreer, Rudolf, 42115 Wuppertal (DE)
(74) Representative: Grünecker, Kinkeldey, Stockmair & Schwanhäusser

(56) References cited:
- EP-A1- 1 577 723
- EP-A1- 1 645 922
- WO-A1-01/82668
- DE-A1- 10 036 237
- DE-A1- 19 640 367

## Description

The present invention generally relates to a modular safety switching device system for actuating actuators in a faile-safe manner. In particular, the present invention relates to a switching device system wherein a plurality of switching devices are connected in series and communicate with each other for indicating the status of the safety switching devices of said system.

Generally, safety relays are apparatuses intended to ensure the safety of humans working in the environment of an industrial process. Safety relays are used, for example, to detect the opening of emergency stop switches or other machine lock-out switches such as interlock switches guarding a gate or limit switches which, for instance, in the form of an optical curtain detect the presence of a human in a predefined hazardous region. Safety relays and safety devices, such as the above-mentioned switches, have to be designed to meet stringent requirements defined in world-wide adapted safety standards. These standards intend to achieve high reliability which is achieved particularly by applying redundancy, diversity, and monitoring principles.

Safety relays, for example, provide internal checking of fault conditions, such as jammed, welded, or stuck contacts of safety switches. Moreover, safety switches, such as limit switches, which already have redundant, normally closed safety contacts for use with dual channel safety relays, are additionally provided with an auxiliary contact for status indication.

Modular safety device systems may comprise a base module, at least one input module and at least one output module. The modules are arranged in a side-by-side fashion on a mounting rail. As for instance known from EP 1 645 922 B1, the modules are interconnected with each other by flat band cables through contact sockets, which are accessible from the outside. The flat band cable provides for the signal flow from the input modules via the base module to the output modules.

The disadvantage of this solution is firstly to be seen in the fact that these flat band cables are accessible from outside and therefore may be tampered with in an unauthorized way. Further, open cables are prone to be influenced by electromagnetic disturbances. Finally, attaching the connecting cables represents a cumbersome additional mounting step.

EP 1 577 723 A1 relates to a modular control system for use in manufacturing plants, machines, or the like. The control system is constructed in a modular way, comprising individual components. Each component is arranged within a closed stand-alone housing, and all the housings are mounted on a rail. Each of the components 2, 3 communicates wirelessly via interfaces 15 and 16. In particular, this wireless communication is formed by an infrared connection. However, also radio communication, inductive or acoustic connections are envisaged. The housings are each completely closed and are transparent to infrared radiation, at least in the region of the interfaces. One module represents a master device, which is connected to a data bus, for instance a CAN bus. The master module may be arranged at an intermediate position or at one of the ends of the row of slave modules.

WO 01/82668 A1 relates to a safety switching device in a modular arrangement. This modular arrangement comprises a plurality of input modules each for processing input signals from a safety transmitter and each for generating output signals. The arrangement further comprises at least two output modules each for driving an actuator responsive to the output signals. The input modules and the output modules are arranged forming a series of modules, and are each associated to one output module. This association of the input modules to the first, second or both output modules is achieved on the basis of the position of the input module within the series of modules. Instead of using a wired bus connection, the data may also be transmitted from one module to the next by means of an optical path. Each of the modules has two redundant transmitting/receiving units and a control unit, which is provided at the end of the series of modules has only one transmitting/receiving unit. The transmitting elements are particularly configured as infrared transmitters. The modules are arranged sidewall to sidewall in order to establish an optical connection between the infrared receivers and the infrared transmitters of the respective modules, and the modules may be mounted to a top hat rail within a switch cabinet.

DE 100 36 237 A1 relates to an input/output (I/O) module for use in a control system having a central computer. The input/output modules provide electrical interfaces for integrating actuators and/or sensors into the control system. Each of those input/output modules is mounted onto a hat rail and represents the respective inputs and outputs of the control system. Some of the input/output modules are for instance related to a temperature sensor module which allows connecting different types of temperature sensors or are adapted to be connected to pressure sensors.

The input/output modules are connected to a power supply via a power bus bar, and comprise in addition to the electric interface, at least one optical communication interface for a wireless communication between adjacent input/output modules. These optical communication interfaces are arranged at adjacent sidewalls of the housing. A bus coupling module is provided for coupling the plurality of input/output modules to the next master module. The bus coupling module can be interpreted as a converter from the wire-bound part of the I/O bus system to the wireless part and vice versa. A closed ring of the optical signal is provided by forming an optical signal return path via light guiding elements. By means of a mechanical movement of the sender upwards or downwards, the respective module can be configured to represent a last or an intermediate component. Depending on the position of a I/O module within the row of modules, same represents-regarding the return path-a passive element conducting the light via the light guides, or the only active element sending the light back to the bus coupling module.

The object underlying the present invention therefore is to provide a modular safety device system, which can be assembled in a particularly easy and cost-effective way and, on the other hand, allows a high level of security for the communication between the individual safety devices.

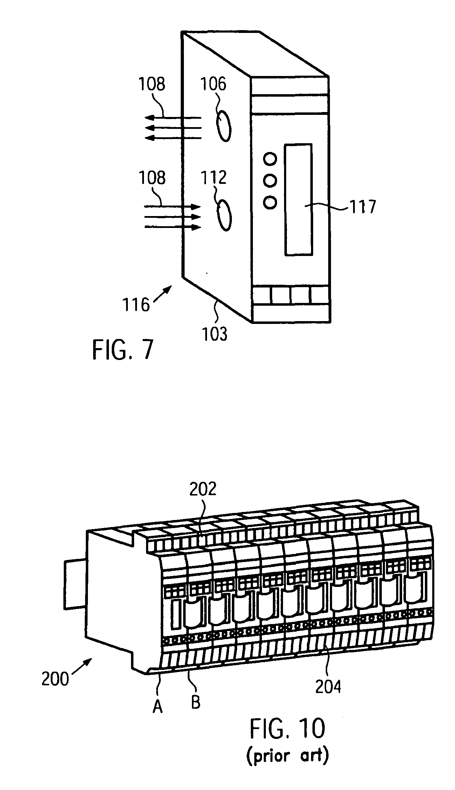

In particular, to link safety devices of known safety systems 200 for logical functions, it is necessary to do that via terminals and wires with known systems, as shown in FIG. 10. The safety device A, for example, is equipped with an output terminal to provide the own safety state. The safety device B is equipped with an input terminal that is connected via a cable 202 to the output terminal of device A. Thus, device B can read the safety information from device A and can control its own safety output by interpreting the information from device A and its own safety state. Logical AND/OR conjunctions are possible. Furthermore, a master device 204 may be provided for diagnosis and configuration of the individual safety devices.

The present invention is based on the idea to dispense with cables and wires and instead provide optical means for the logical link between the individual safety devices.

According to the present invention, all data transmission between the components is achieved via optical transferal with the advantage that no additional wiring for the link is necessary.

According to a first embodiment of the present invention, the safety devices each have a housing and within the housing a small hole is provided. Behind the hole on one side of the housing an optical receiver, for instance an infrared photo transistor, is arranged, and behind a hole on the opposite side of the housing an optical transmitter, for instance, an infrared LED (light emitting diode) is arranged. The two openings are aligned to each other so that the transmitter of one safety device can communicate with the receiver of the adjacent safety device, when both devices are mounted on a mounting rail.

The received optical data are converted into electrical data within the safety device and are read by an integrated microprocessor. This microprocessor interprets the information together with the own safety state of the respective safety device, and sends an electrical signal to the optical transmitter. The safety devices can be configured to an AND or an OR conjunction. Besides replacing the additional wiring, the optical communication according to the present invention has the advantage of an enhanced EMC stability (electromagnetic compatibility).

According to an advantageous embodiment of the present invention, there is not only provided a communication between individual safety devices, but also to a gateway which is able to convert the optical data into electrical data to be transmitted via a communication bus protocol.

To the accomplishment of the foregoing and related ends, certain illustrative aspects of the disclosed innovation are described herein in connection with the following description and the annexed drawings. These aspects are indicative, however, of but a few of the various ways in which the principles disclosed herein can be employed as is intended to include all such aspects and their equivalents. Other advantages and novel features will become apparent from the following detailed description when considered in conjunction with the drawings.
- **Fig.** 1: shows a perspective view of a first safety device according to the present invention;
- **Fig. 2**: shows a perspective view of a second safety device according to the present invention;
- **Fig. 3**: shows a front view of two safety devices when mounted in a communicating manner;
- **Fig. 4**: shows an example of a light signal sent from one safety device to another;
- **Fig. 5**: shows a schematic representation of a safety device which can be implemented in an optical bus system;
- **Fig. 6**: shows a schematic representation of a modular system of safety devices interconnected via an optical link and communicating via a gateway with another bus;
- **Fig. 7**: shows a perspective view of the gateway of FIG. 6;
- **Fig. 8**: shows a block diagram of two communicating safety devices;
- **Fig. 9**: shows a flowchart of an automatic address assignment procedure;
- **Fig. 10**: shows a perspective view of a known modular safety system comprising flat cable interconnections.

The innovation is now described with reference to the drawings, wherein like reference numerals are used to refer to like elements throughout. In the following description, for purposes of explanation, numerous specific details are set forth in order to provide a thorough understanding thereof. It may be evident, however, that the innovation can be practiced without these specific details. In other instances, well known structures and devices are shown in block diagram form in order to facilitate a description thereof.

As used in this application, the terms "component", "system", "equipment", "interface", "network" and/or the like are intended to refer to a computer related entity, either hardware a combination of hardware and software, software or software in execution. For example, a component can be, but is not limited to being, a process running on a processor, or a processor, a harddisk drive, multiple storage drives (of optical and/or magnetic storage medium), an object, an executable, a thread of execution, a program and/or a computer, an industrial controller, a relay, a sensor and/or a variable frequency drive. By way of illustration, both an application running on a server and a server can be a component. One or more components can reside within a process and/or thread of execution, and a component can be localized on one computer and/or distributed between two or more computers.

In addition to the foregoing, it should be appreciated that the claimed subject matter can be implemented as a method, apparatus, or article of manufacture using typical programming and/or engineering techniques to produce software, firmware, hardware, or any suitable combination thereof to control a computing device, such as a variable frequency drive and controller, to implement the disclosed subject matter. The term "article of manufacture" as used herein is intended to encompass a computer program accessible from any suitable computer-readable device, media, or a carrier generated by such media/device. For example, computer readable media can include but are not limited to magnetic storage devices (e*.g*., hard disk, floppy disk, magnetic strips...), optical disks *(e.g*., compact disk (CD), digital versatile disk (DVD)...), smart cards, and flash memory devices *(e.g*., card, stick, key drive...). Additionally it should be appreciated that a carrier wave generated by a transmitter can be employed to carry computer-readable electronic data such as those used in transmitting and receiving electronic mail or in accessing a network such as the Internet or a local area network (LAN). Of course, those skilled in the art will recognize many modifications may be made to this configuration without departing from the scope or spirit of the claimed subject matter.

Moreover, the word "exemplary" is used herein to mean serving as an example, instance, or illustration. Any aspect or design described herein as "exemplary" is not necessarily to be construed as preferred or advantageous over other aspects or designs. Rather, use of the word exemplary is intended to present concepts in a concrete fashion. As used in this application, the term "or" is intended to mean an inclusive "or" rather than an exclusive "or". That is, unless specified otherwise, or clear from context, "X employs A or B" is intended to mean any of the natural inclusive permutations. That is, if X employs A; X employs B; or X employs both A and B, then "X employs A or B" is satisfied under any of the foregoing instances. In addition, the articles "a" and "an" as used in this application and the appended claims should generally be construed to mean "one or more" unless specified otherwise or clear from context to be directed to a singular form.

Furthermore, the terms to "infer" or "inference", as used herein, refer generally to the process of reasoning about or inferring states of the system, environment, and/or user from a set of observations as captured via events and/or data. Inference can be employed to identify a specific context or action, or can generate a probability distribution over states, for example. The inference can be probabilistic-that is, the computation of a probability distribution over states of interest based on a consideration of data and events. Inference can also refer to techniques employed for composing higher-level events from a set of events and/or data. Such inference results in the construction of new events or actions from a set of observed events and/or stored event data, whether or not the events are correlated in close temporal proximity, and whether the events and data come from one or several event and data sources.

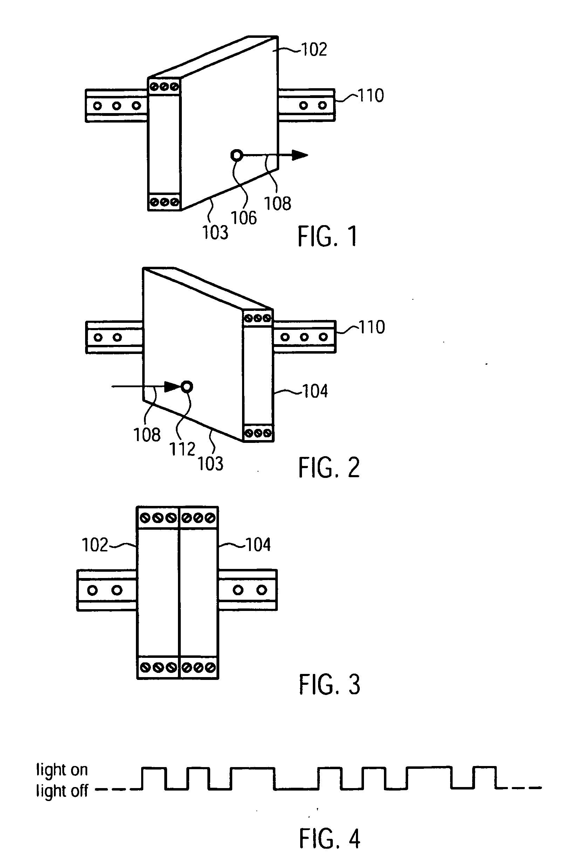

Referring to the drawings, FIG. 1 depicts a first safety device 102 according to the present innovation. As can be seen from FIG. 1, the safety device 102 has an opening 106 within its housing 103 through which an optical signal 108 can be emitted. This optical signal 108 can for instance be a pulsed infrared radiation. For performing a communication with a second safety device 102, the first safety device 102 is mounted on a mounting rail 110, which can for instance be a so-called top hat rail or DIN rail. A second safety device 104 is mounted adjacently to the first safety device 102 at the mounting rail 110, as shown in FIG. 2. Safety device 104 has a corresponding opening 112 for receiving the optical signal 108 from the first safety device 102.

As shown in FIG. 3, safety devices 102 and 104 are mounted on the mounting rail 110 preferably in a way that they touch each other, so that no scattered ambient light can interfere with the optical signal 108, transmitted from one safety device to the other. Preferably, the opening 106 and 112 are arranged to align with each other.

FIG. 4 shows a possible sample of a pulse train for the optical signal 108. As shown in the following table 1, the safety devices can be configured according to an and or an or conjunction.

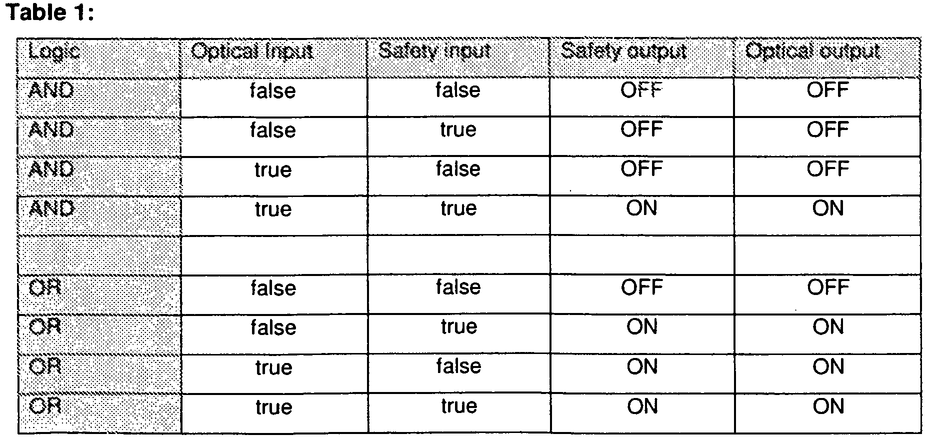

The optical serial transmission signal can have the following states: light constantly ON, light constantly OFF, or pulsed light pattern, for instance, short ON, short OFF, short ON, short OFF, long ON, long OFF, and repeat this pattern from the beginning. This signal pulse train is shown in FIG. 4.

The receiving device 104 interprets these states to the following results:
Light constantly ON: safety state from the transmission device is OFF
Light constantly OFF: safety state from the transmission device is OFF
Light pattern as shown in FIG. 4: safety state from the transmission device is ON

By using such a light pattern, static states of the light never run into dangerous situations and therefore, the safety requirements for such a data transmission can be met.

Of course, any number of devices 102, 104, in which a state of the safety devices is transmitted unidirectionally, can be assembled in line with FIG. 3. Furthermore, the devices have to be configured whether an AND or an OR conjunction has to be interpreted.

According to a further embodiment of the present invention, not only a unidirectional but also a bidirectional, for instance, a ring-shaped communication of a plurality of safety devices can be achieved.

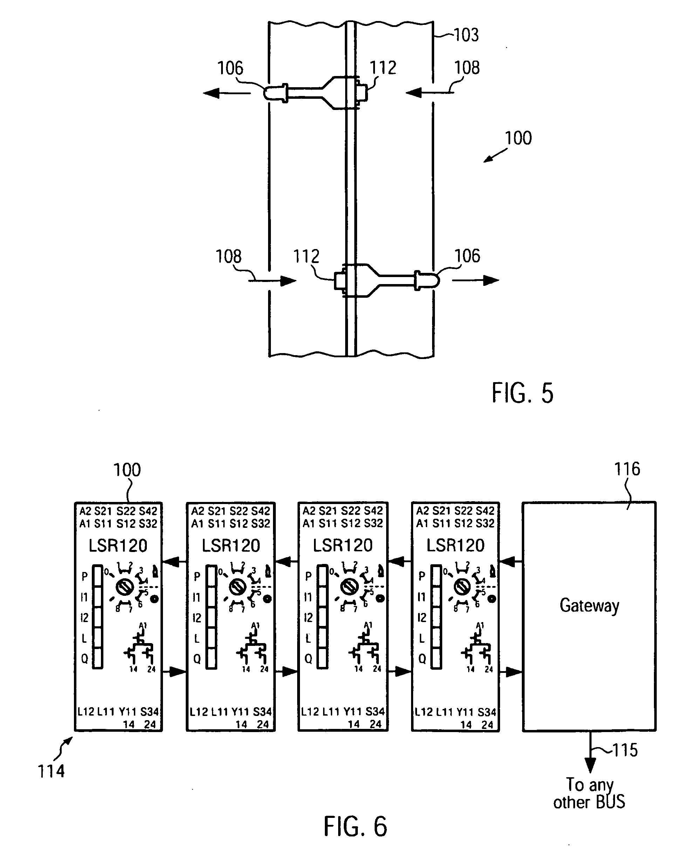

As shown schematically in FIG. 5, each safety device 100 can be equipped with two openings at each sidewall of the housing 103 for sending and receiving optical signals indicative of the safety status of the respective safety device 100. As shown in FIG. 6, a plurality of such safety devices 100 with a bidirectional optical link can be joined to form a modular safety device system 114. The light emitting device 106 can be an infrared light emitting diode, LED, and the light receiving device 112 can be a photo transistor sensitive for infrared radiation. Other optical wavelengths besides infrared radiation are of course also usable, as well as different receiver principles, such as photodiodes or photo resistors, can be used. Furthermore, instead of light emitting diodes also laser diodes can be applied.

According to the present innovation, the optical data transmission within the modular safety device system is used for diagnosis and configuration of the safety devices 100. To this end, a gateway 116 is provided for converting the data coming from a bus or PC or other control units into an optical signal.

The gateway 116 works as a master in the safety device system 114 and controls the communication. For the communication, for example, a so-called MODBUS protocol can be used.

MODBUS is as serial communication protocol for use with programmable logic controllers (PLC), in particular, it is used for transmitting information over serial lines between electronic devices. The device requesting information is called the MODBUS master and the devices supplying information are MODBUS slaves. In a standard MODBUS network, there is one master and up to 247 slaves, each with a unique slave address from one to 247. The master may also write information to the slaves.

MODBUS is an open protocol; therefore, it has become a standard communications protocol in industry by being the most commonly available means of connecting industrial electronic devices. The official MODBUS specification can be found at www.modbus-ida.org.However, other bus protocols are of course also applicable with the present invention.

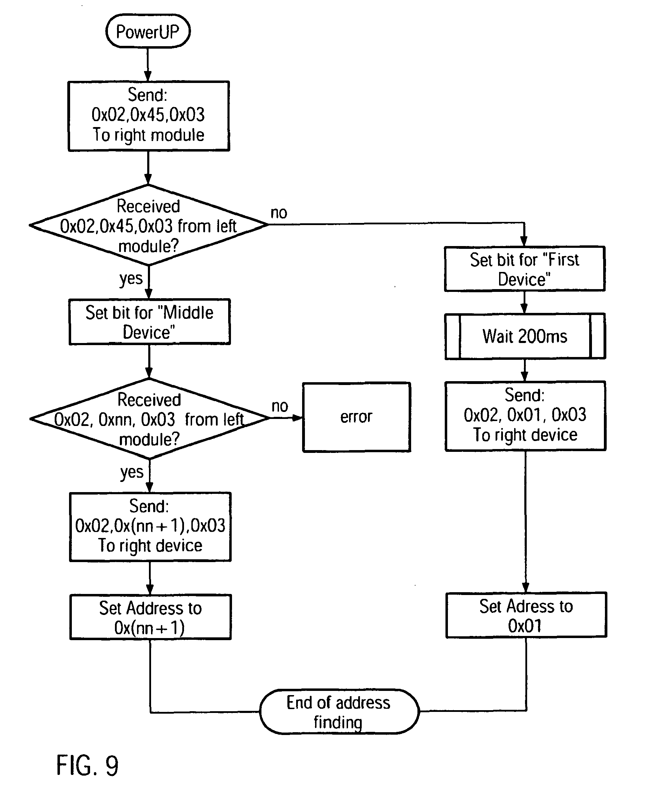

The gateway 116 sends a query to a member 100 of the safety system 114 and the asked device replies with the diagnostic data. On the other hand, the master or gateway 116 can also send configuration data to the member 100. In this case, the device replies thereto with a confirmation of the data. For that kind of communication, each member 100 of the system needs to have a unique address. This address can either be set by hardware switches or can be given automatically as will be set forth in the following with reference to FIG. 9.

FIG. 7 shows a perspective view of the gateway 116 with a respective optical transmitter and receiver in the sidewall of the housing 103. An electrical connector 117 to be connected to another than optical bus 115 is provided at the front of gateway 116 in order to be accessible for an operator. However, a wireless connection for instance via Bluetooth is also possible.

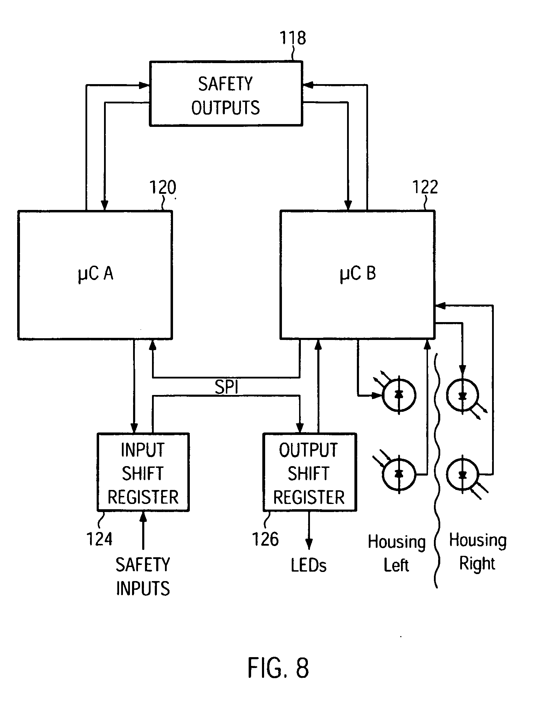

FIG. 8 shows a block diagram of a safety device 100 according to the present innovation. As can be derived from FIG. 8, the safety outputs 118 communicate with two microcontrollers 120 and 122. Microcontroller A receives data only from microcontroller B 122 and the safety outputs. Microcontroller B, on the other hand, is responsible for the conversion of optic signals into electric signals and vice versa. Furthermore, an input shift register 124 receives the signals from the safety inputs and communicates same via, for instance, a serial peripheral interface, SPI, bus. From the output shift register 126 status indicating LEDs provided at the housing and being visible for a user, are activated as well as the microcontroller B 122. Microcontroller B processes the information from the output shift register 126 and provides the necessary information for the safety outputs 118.

This highly redundant architecture enhances significantly the safety of the modular safety device system according to the present innovation.

**Tables 2** to 5 summarize examples of communication codes for the communication using a simplified MODBUS protocol. If a safety device 100, representing a member of the bus system, receives data that are not addressed to same, the device 100 forwards those data without any changes to the next device within the line.

**Table 2:**

| Code | Name | Meaning |
|---|---|---|
| 0x01 | Illegal Function | The function code is not supported by the Device |
| 0x02 | Illegal Data Address | The data address in the query is not allowed for the Device |
| 0x03 | Illegal Data Value | The data value in the query is not valid |

**Table 3:**

| Code | Name | Meaning |
|---|---|---|
| 0x03 | Read Multiple Registers | Reads the contents of a sequence of registers |
| 0x06 | Write Single Register | Writes a value to a single register |

**Table 4:**

| Query | |
|---|---|
| **Fieldname** | **Example** |
| Slave Address | 0x01 |
| Function Code | 0x03 |
| Start Address (High byte) | 0x00 |
| Start Address (Low byte) | 0x02 |
| Number of registers (High byte) | 0x00 |
| Number of registers (Low byte) | 0x02 |
| CRC (High byte) | 0x65 |
| CRC (Low byte) | 0xCB |

| Response | |
|---|---|
| **Fieldname** | **Example** |
| Slave Address | 0x01 |
| Function Code | 0x03 |
| Byte Count | 0x04 |
| Data (High byte) | 0x1 F |
| Data (Low byte) | 0x70 |
| Date (High byte) | 0xC0 |
| Data (Low Byte) | 0x94 |
| CRC (High byte) | 0xAD |
| CRC (Low byte) | 0xFF |

| Error Response | |
|---|---|
| **Fieldname** | **Example** |
| Slave Address | 0x01 |
| Function Code | 0x83 |
| Exception Code | (see supported exception codes) |
| CRC (High byte) | 0x... |
| CRC (Low byte) | 0x... |

**Table 5:**

| Query | |
|---|---|
| **Fieldname** | **Example** |
| Slave Address | 0x01 |
| Function Code | 0x06 |
| Start Address (High byte) | 0x00 |
| Start Address (Low byte) | 0x03 |
| Data (High byte) | 0x00 |
| Data (Low byte) | 0x02 |
| CRC (High byte) | 0xF8 |
| CRC (Low byte) | 0x0B |

| Response | |
|---|---|
| **Fieldname** | **Example** |
| Slave Address | 0x01 |
| Function Code | 0x03 |
| Start Address (High byte) | 0x00 |
| Start Address (Low byte) | 0x03 |
| Data (High byte) | 0x00 |
| Data (Low byte) | 0x02 |
| CRC (High byte) | 0x34 |
| CRC (Low byte) | 0x0B |

| Error Response | |
|---|---|
| **Fieldname** | **Example** |
| Slave Address | 0x01 |
| Function Code | 0x86 |
| Exception Code | (see supported exception codes) |
| CRC (High byte) | 0x... |
| CRC (Low byte) | 0x... |

FIG. 9 shows an exemplary flow chart of assigning the addresses of the individual safety devices 100 during power up. In the first step the safety device sends a request to the module on the right-hand side. In the next step, each device checks what signal was received from the left-hand side. In case that no signal came from the left-hand side, the respective module/model must have been the first device in the row and accordingly sets a bit indicating that it is the first device. This first device sends a signal indicating that it is the first device to the adjacent safety device and sets its address to 0x01.

In this case, the first device has found its address. Alternatively, if the respective safety device receives a message from the left module, it sets a bit for "middle devices" and procedes to checking whether it received an address from the left module. If not, an error had occurred and the procedure must start again or a warning has to be output. If yes, the slave chooses and address which is one integer higher than the one assigned to the left-hand module and informs the right-hand side device about this address. If all middle devices and the first device have assigned their addresses, the address finding process of FIG. 9 is finished.

## Claims

1. Modular safety switching device system (114) for actuating actuators in a fail-safe manner, said system comprising:
at least one first safety device (102; 100);
at least one second safety device (104; 100);
wherein said first and second safety devices (102, 104; 100) are connected to each other via an optical link (106, 108, 112) that transmits optical data bidirectionally;
wherein each of said at least one first and second safety devices (102, 104; 100) comprises:
safety inputs for receiving signals from safety transmitters;
at least one safety output (118) for outputting an output signal for actuating actuators in a fail-safe manner;
a first microprocessor (120) being coupled to the safety inputs and to the at least one safety output (118) for said generating output signal; and
a second microprocessor (122) for converting received optical data into electrical data and for processing the electrical data together with a safety state of the respective safety device (102, 104; 100), and for generating an electrical signal to be output via the optical link, wherein said second microprocessor (122) is coupled to said at least one safety output (118) and to said first microprocessor (120).

2. System according to claim 1, wherein each safety device has a housing (103), and wherein the at least one first safety device (102) comprises an optical transmitter (106) arranged in a first opening of said housing, and wherein the at least one second safety device (104) comprises an optical receiver (112) arranged in a second opening of said housing.

3. System according to claim 2, wherein said optical receiver (112) comprises an infrared phototransistor or a photo diode, and wherein said optical transmitter (106) comprises an infrared light emitting diode, LED.

4. System according to one of the preceding claims, wherein said safety devices (102, 104) are arranged on a mounting rail (110).

5. System according to one of the preceding claims, further comprising a plurality of safety transmitters, each for generating a safety switching event; wherein said first and second safety devices (102, 104; 100) comprise:
a plurality of input modules for fail-safely evaluating said safety switching events and for generating output signals;
a plurality of output modules for fail-safely actuating an actuator in response to the output signals; and
a control module for controlling said input modules and output modules.

6. System according to one of the preceding claims, further comprising a gateway module (116) for connecting said optically linked safety devices (100, 102, 104) with a non-optical bus.

7. System according to one of the preceding claims, wherein said safety devices (100) are coupled serially in a way that an optical signal is passed from a first to a last safety device through all safety devices in one direction and back again from the last to the first safety device, in order to form a ring shaped data transmission system.

8. System according to one of the preceding claims, wherein said safety devices (100) are operable to set their addresses automatically during a power-up procedure.

9. System according to one of the claims 1 to 7, wherein said safety devices (100) comprise hardware means to set their addresses.

## Patentansprüche

1. Modulares Sicherheitsschalteinrichtungssystem (114) zum Betätigen von Aktuatoren auf ausfallsichere Weise, wobei das System Folgendes umfasst:
mindestens eine erste Sicherheitseinrichtung (102; 100);
mindestens eine zweite Sicherheitseinrichtung (104; 100);
wobei die erste und zweite Sicherheitseinrichtung (102, 104; 100) miteinander über eine optische Verbindung (106, 108, 112) verbunden sind, die optische Daten bidirektional überträgt;
wobei jede der mindestens einen ersten und zweiten Sicherheitseinrichtung (102, 104; 100) Folgendes umfasst:
Sicherheitseingänge zum Empfangen von Signalen von Sicherheitssendern;
mindestens einen Sicherheitsausgang (118) zum Ausgeben eines Ausgangssignals zum Betätigen von Aktuatoren auf ausfallsichere Weise;
einen ersten Mikroprozessor (120), der an die Sicherheitseingänge und an den mindestens einen Sicherheitsausgang (118) zum Generieren des Ausgangssignals gekoppelt ist; und
einen zweiten Mikroprozessor (122) zum Umwandeln empfangener optischer Daten in elektrische Daten und zum Verarbeiten der elektrischen Daten zusammen mit einem Sicherheitszustand der jeweiligen Sicherheitseinrichtung (102, 104; 100) und zum Generieren eines elektrischen Signals zur Ausgabe über die optische Verbindung, wobei der zweite Mikroprozessor (122) an den mindestens einen Sicherheitsausgang (118) und an den ersten Mikroprozessor (120) gekoppelt ist.

2. System nach Anspruch 1, wobei jede Sicherheitseinrichtung ein Gehäuse (103) aufweist und wobei die mindestens eine erste Sicherheitseinrichtung (102) einen in einer ersten Öffnung des Gehäuses angeordneten optischen Sender (106) umfasst und wobei die mindestens eine zweite Sicherheitseinrichtung (104) einen in einer zweiten Öffnung des Gehäuses angeordneten optischen Empfänger (112) umfasst.

3. System nach Anspruch 2, wobei der optische Empfänger (112) einen Infrarotfototransistor oder eine Fotodiode umfasst und wobei der optische Sender (106) eine Infrarotleuchtdiode, LED, umfasst.

4. System nach einem der vorhergehenden Ansprüche, wobei die Sicherheitseinrichtungen (102, 104) auf einer Montageschiene (110) angeordnet sind.

5. System nach einem der vorhergehenden Ansprüche, ferner umfassend mehrere Sicherheitssender, jeweils zum Erzeugen eines Sicherheitsschaltereignisses, wobei die erste und zweite Sicherheitseinrichtung (102, 104; 100) Folgendes umfassen:
mehrere Eingangsmodule zum ausfallsicheren Evaluieren der Sicherheitsschaltereignisse und zum Generieren von Ausgangssignalen;
mehrere Ausgangsmodule zum ausfallsicheren Betätigen eines Aktuators als Reaktion auf die Ausgangssignale;
ein Steuermodul zum Steuern der Eingangsmodule und Ausgangsmodule.

6. System nach einem der vorhergehenden Ansprüche, weiterhin umfassend ein Gatewaymodul (116) zum Verbinden der optisch verbundenen Sicherheitseinrichtungen (100, 102, 104) mit einem nichtoptischen Bus.

7. System nach einem der vorhergehenden Ansprüche, wobei die Sicherheitseinrichtungen (100) auf eine Weise seriell gekoppelt sind, dass ein optisches Signal in einer Richtung von einer ersten zu einer letzten Sicherheitseinrichtung und wieder zurück von der letzten zu der ersten Sicherheitseinrichtung durch alle Sicherheitseinrichtungen weitergeleitet wird, um ein ringförmiges Datenübertragungssystem auszubilden.

8. System nach einem der vorhergehenden Ansprüche, wobei die Sicherheitseinrichtungen (100) betätigt werden können, ihre Adressen während einer Einschaltprozedur automatisch zu setzen.

9. System nach einem der Ansprüche 1 bis 7, wobei die Sicherheitseinrichtungen (100) Hardwaremittel zum Setzen ihrer Adressen umfassen.

## Revendications

1. Système de dispositif de commutation de sécurité modulaire (114) pour actionner des actionneurs de manière sans-panne, lequel système comprend :
- au moins un premier dispositif de sécurité (102 ; 100) ;
- au moins un second dispositif de sécurité (104 ; 100) ;
- dans lequel lesdits premiers et seconds dispositifs de sécurité (102, 104 ; 100) sont connectés les uns aux autres par une liaison optique (106, 108, 112) qui transmet des données optiques de manière bidirectionnelle ; et
- dans lequel chacun desdits au moins un premier et second dispositifs de sécurité (102, 104 ; 100) comprend :
- des entrées de sécurité pour recevoir des signaux depuis des émetteurs de sécurité ;
- au moins une sortie de sécurité (118) pour émettre un signal de sortie afin d'actionner les actionneurs de manière sans-panne ;
- un premier microprocesseur (120) couplé aux entrées de sécurité et à ladite au moins une sortie de sécurité (118) afin de générer ledit signal de sortie ; et
- un second microprocesseur (122) afin de convertir les données optiques reçues en données électriques et de traiter les données électriques avec un état de sécurité du dispositif de sécurité respectif (102, 104 ; 100), et afin de générer un signal électrique devant être émis via la liaison optique, lequel second microprocesseur (122) est couplé à ladite au moins sortie de sécurité (118) et audit premier microprocesseur (120).

2. Système selon la revendication 1, dans lequel chaque dispositif de sécurité comprend un boîtier (103), et dans lequel ledit au moins un premier dispositif de sécurité (102) comprend un émetteur optique (106) disposé dans une première ouverture dudit boîtier, et dans lequel ledit au moins un second dispositif de sécurité (104) comprend un récepteur optique (112) disposé dans une seconde ouverture dudit boîtier.

3. Système selon la revendication 2, dans lequel ledit récepteur optique (112) comprend un phototransistor infrarouge ou une photodiode, tandis que ledit émetteur optique (106) comprend une diode électroluminescente (LED) infrarouge.

4. Système selon l'une des revendications précédentes, dans lequel lesdits dispositifs de sécurité (102, 104) sont disposés sur un rail de montage (110).

5. Système selon l'une des revendications précédentes, comprenant en outre plusieurs émetteurs de sécurité qui génèrent chacun un événement de commutation de sécurité, lesdits premier et second dispositifs de sécurité (102, 104 ; 100) comprenant :
- plusieurs modules d'entrée afin d'évaluer de manière sans-panne lesdits événements de commutation de sécurité et de de générer des signaux de sortie ;
- plusieurs modules de sortie afin d'actionner de manière sans-panne un actionneur en réponse aux signaux de sortie ; et
- un module de commande afin de commander lesdits modules d'entrée et lesdits modules de sortie.

6. Système selon l'une des revendications précédentes, comprenant en outre un module de passerelle (116) afin de connecter lesdits dispositifs de sécurité (100, 102, 104) connectés optiquement avec d'un bus non optique.

7. Système selon l'une des revendications précédentes, dans lequel lesdits dispositifs de sécurité (100) sont couplés en série de sorte qu'un signal optique soit transmis d'un premier à un dernier dispositif de sécurité via tous les dispositifs de sécurité dans une direction, puis dans l'autre sens du dernier au premier dispositif de sécurité, de manière à former un système de transmission de données en forme d'anneau.

8. Système selon l'une des revendications précédentes, dans lequel lesdits dispositifs de sécurité (100) sont conçus de manière à établir automatiquement leurs adresses pendant une procédure de mise en marche.

9. Système selon l'une des revendications 1 à 7, dans lequel les dispositifs de sécurité (100) comprennent des moyens matériels pour établir leurs adresses.
